# EUROPEAN PATENT SPECIFICATION

(11) **EP 4 537 027 B1**
(45) Date of publication and mention of the grant of the patent: **22.04.2026**
(21) Application number: 23730803.6
(22) Date of filing: 05.06.2023
(51) Int. Cl.: F24S 70/225

(54) **SPECTRALLY SELECTIVE ABSORBING COATING FOR SOLAR RECEIVERS ACTING IN AIR**
SPEKTRAL SELEKTIVE ABSORBIERENDE BESCHICHTUNG FÜR IN LUFT WIRKENDE SOLAREMPFÄNGER
REVÊTEMENT ABSORBANT SPECTRALEMENT SÉLECTIF POUR RÉCEPTEURS SOLAIRES AÉRIENS

(30) Priority: 07.06.2022 IT 202200012065
(43) Date of publication of application: 16.04.2025
(73) Proprietor: ENEA - Agenzia nazionale per le nuove tecnologie, l'energia e lo sviluppo economico sostenibile, 00196 Roma (IT)
(72) Inventor: D'ANGELO, Antonio, 00196 Roma (IT); DILETTO, Claudia, 00196 Roma (IT); ESPOSITO, Salvatore, 00196 Roma (IT); GRADITI, Giorgio, 00196 Roma (IT); GUGLIELMO, Antonio, 00196 Roma (IT); LANCHI, Michela, 00196 Roma (IT)
(74) Representative: Leone, Mario
(86) International application number: PCT/EP2023/064952
(87) International publication number: WO 2023/237475

(56) References cited:
- WO-A1-2022/024064
- CN-A- 106 679 202
- DE-A1- 102013 110 118
- US-A1- 2011 249 326
- US-A1- 2014 329 073
- US-A1- 2019 368 026

## Description

The present invention relates to a spectrally selective absorbing coating for receivers acting in air and, in particular, for receiver tubes acting in air of solar thermal and thermodynamic systems for the production of thermal and/or electric energy, with special reference to the solar thermal and thermodynamic with parabolic or Fresnel linear collector concentrating systems. The receiver of these systems has tubular geometry, and it has to absorb the highest possible amount of solar radiation concentrated thereon and, at the same time, to disperse towards the external environment the least possible amount of heat.

Such function is performed by a particular surface coating applied on the tube, typically made of steel, in which a heat transfer fluid flows; said tube is designated hereinafter even with the wording "substrate" in relation to the fact that a coating is applied thereon.

In order to effectively fulfil such function, the surface coating of the receiver has to show reflectance optical properties varying depending upon the wavelength. In particular, in order to obtain a solar receiver having high photo-thermal efficiency, the coating has to show a behaviour as close as possible to the ideal one, that is zero reflectance (unitary absorbance) in the spectral region of the solar radiation (0.3-2.0 µm) and unitary reflectance (zero absorbance and emissivity) in the spectral region of the thermal infrared (wavelength 2.0-40.0 µm), with a step transition (cut-off) between the two regions.

Following this, when one refers to the this kind of coating, the use of the term "spectrally selective absorbing coating" for solar receivers is established. In order to obtain such behaviour, the spectrally selective absorbing coating is generally formed by a complex multi-layered structure, having in sequence, starting from the substrate, a reflector in the infrared region, an absorber of the solar radiation and, at last, an anti-reflective coating to minimize the losses by reflection of the solar radiation. Each one of the above-mentioned elements (infrared reflective coating, solar absorber, anti-reflective coating) of the absorbing coating consists of one or more layers of materials suitably selected so that their optical properties concur in reaching the wished performances of high solar absorbance (αₛ) and low thermal emissivity (εₜₕ) at the operating temperatures of the receiver that is, as a whole, of high efficiency in the photo-thermal conversion (ηₚₜ) of the absorbing coating.

In particular, the solar radiation is generally absorbed by means of composite materials of Cermet type, consisting of a ceramic phase and a metal phase. Such materials allow to have high absorptions in the spectral region of the solar radiation and a good transparency in the spectral region of the thermal infrared, by giving to the coating a behaviour close to the ideal one.

The receiver tube acting in air can consist only of the steel tube coated with the absorbing coating (not incapsulated receiver tube) or of the steel tube coated with the incapsulated absorbing coating by means of an external tube made of glass (incapsulated receiver tube). In both cases, the coating is in contact with air, therefore it is subjected to degradation mechanisms accelerated by phenomena of oxidative type involving the metal portions of the coating with consequent deterioration of the photo-thermal performances.

These phenomena negatively affect the durability of the absorbing coating and the higher the operation temperature of the receiver tube is, the more the phenomena become relevant.

The spreading of the technology of the receiver tubes in air, both the not incapsulated ones and the incapsulated ones, was strongly limited due to the difficulty in implementing receiver tubes operating at average (400°C) and high temperature (550°C), with photo-thermal performances and durability comparable to those of the more expensive incapsulated and evacuated receiver tubes.

An example of solution to the above-mentioned technical problem is provided in the international application n. WO 2022/024064 A1, disclosing a solar absorber coating capable to increase the structure stability of the medium-high reflectance metals, thereby a solar absorber coating is obtained with improved photothermal performances at high temperatures.

Moreover, in the art, several publications can be found describing both solar absorbing coatings using metal components capable of resisting to oxidation, such as the self-passivating alloys, and absorbing coatings incapsulated by dense layers with the double function of anti-reflective filter and oxidation barrier.

In this last case, the solutions to be adopted to implement these coatings are very complex and expensive and the required deposition processes have a high cost, not compatible with the industrial production.

The technical problem underlying the present invention is to provide a spectrally selective absorbing coating, a receiver using it and a process for its implementation, so to avoid the drawbacks mentioned with reference to the state of the art.

Such problem is solved by an absorbing coating as above specified, a receiver and an implementation process as defined in the respective enclosed independent claims.

The main advantage of the spectrally selective absorbing coating according to the invention lies in comprising one or more structures capable of protecting their metal component and the metal components of the absorbing coating against the atmospheric oxidizing agents by making it suitable to operate directly in air for use temperatures up to 1200°C.

This protective structure is also suitable to be implemented with the same deposition techniques used to implement the different portions of the absorbing coating which are: the physical vapour deposition (PVD) techniques and, in particular, the techniques of high repeatability and productivity sputtering type.

The present invention will be described hereinafter according to some preferred embodiments, provided by way of example and not for limitative purposes with reference to the enclosed drawings wherein:
- figure 1 shows a schematic section view of a protective structure of an absorbing receiver according to the invention;
- figure 2 shows a schematic section view of a first embodiment of absorbing coating according to the invention;
- figure 3 shows a schematic section view of a second embodiment of absorbing coating according to the invention;
- figure 4 shows a schematic section view of a third embodiment of absorbing coating according to the invention; and
- figure 5 shows a diagram illustrating the reflectance course of the protective structure deposited on steel substrate in the spectral range of 250-2500 nm.

In the drawings, for a simpler and clearer representation, the shown elements were not necessarily drawn to scale.

With reference to figures, the present invention relates to a spectrally selective absorbing coating for receivers acting in air of solar thermal and thermodynamic systems, designated as a whole with 2.

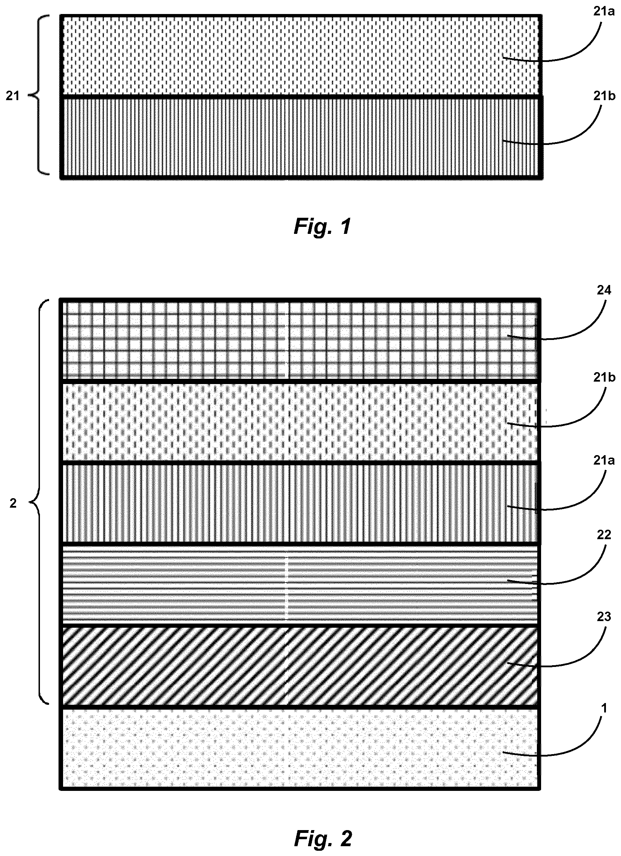

The absorbing coating 2 is arranged in a substrate 1 an, it generally comprises at least a protective structure 21 (figure 1) capable of protecting both its metal component and the metal components of said absorbing coating 2 against the atmospheric oxidizing agents; each protective structure 21 of the absorbing coating 2 comprises a metal layer 21a whereon a ceramic layer 21b is arranged.

The metal layer 21a consists of an alloy comprising at least two metals, in particular:
- a first metal, present in the metal layer 21a in alloy with atomic percentages comprised between 50% and 90%, selected in the group consisting of: W, Mo, Ta, Nb, Ni, Co, Cu, Hf, Fe, Ag, Au, Pt, Pd, Cr, Rh; and
- a second metal, present in the metal layer 21a in alloy with atomic percentages comprised between 10% and 50%, selected in the group consisting of: Cr, Al, Si, Ti, Zr.

Gibbs free energy of the second metal, for the formation of its oxide, has to be lower than that of the first metal.

The ceramic layer 21b comprises a sub-stoichiometric oxide of a metal material, selected in the group consisting of: Al, Si, alloy of Al and Si, Gibbs free energy thereof of formation of its oxide has to be lower than or equal to that of the above-mentioned second metal.

Said metal alloy can include all possible combinations between the first and the second metal, on condition that said metal alloy is not NiCr, HfZr.

The above-described protective structure 21 can operate at an operating temperature, which constitutes a piece of data provided during planning, up to 1200°C, preferably up to 800°C.

The first constituent metal, defined "primary", must have medium-high reflecting optical features in the spectral range of 2-40 µm and it must have a structural and chemical-physical stability at the operating temperature provided for the absorbing coating 2.

The second constituent metal, defined "secondary", must have the capability of forming, once in contact with oxygen, uniform and compact oxides, particularly stable and resistant to the operating temperature provided for the absorbing coating 2.

The metal layer 21a has to be coated with said ceramic layer 21b which must have the features described hereinafter.

The ceramic layer 21b has a structural and chemical-physical stability in air at the operating temperature provided for the absorbing coating 2, and the oxide of the ceramic layer 21b has to be deposited in sub-stoichiometric form with oxygen atomic percentages which will be decreasing as the operating temperature provided for the absorbing coating 2 increases.

Moreover, as the operating temperature provided for the absorbing coating 2 increases, the atomic percentages of the first metal have to decrease whereas those of the second metal have to increase.

The alloy of the metal layer 21a, apart from the "primary" and "secondary" element, can include a third metal, defined "tertiary", which has the function of improving the structural stability and the adhesion property of the protective structure 21 at the operating temperature of the absorbing coating 2. The "tertiary" metals to be used for this purpose can be selected in the group consisting of: Y, Ti, Zr, and their atomic percentage within the alloy varies between 1% and 10%.

When the alloy is a ternary alloy, or more, it comprises all possible combinations between the first, the second and the third metal on condition that said metal alloy is not NiCrAlY.

Once the protective structure 21 is exposed to the air at a fixed operating temperature, a required condition so that a barrier oxide layer at the metal layer 21a - ceramic layer 21b interface is formed is that the selective oxidation of the "secondary" metal element only of the alloy at the metal layer 21a - ceramic layer 21b interface takes place.

In this way, an oxide is obtained which can play the role of effective barrier both to the spreading of the oxidising agents existing in the atmosphere in the metal layer 21a and to the spreading of the components of the metal layer 21a in the overlying ceramic layer 21b.

In order to promote, at the operating temperature, the selective oxidation of the "secondary" metal element only of the alloy at the metal layer 21a - ceramic layer 21b interface, one has to select a "secondary" metal element of the alloy having Gibbs free energy of formation of its oxide lower than that of the "primary" metal element, and to manage carefully the amounts of oxygen (main oxidizing agent present in the air) and of the "secondary" metal element of the alloy present at the metal layer 21a - ceramic layer 21b interface.

Practically, in order to have a good selective oxidation, in each moment the oxygen which comes in contact with the surface of the metal layer 21a has to be in equal or lower amount than that of the "secondary" metal present on such surface.

If such condition is not met, the exceeding amounts of oxygen could oxidize other elements of the metal layer 21a, with formation of mixed oxides or oxides rich in the "primary" metal element of the alloy and consequent loss in the features of uniformity, compactness, stability and resistance of the oxides rich in the "secondary" metal element of the alloy.

The management of the amount of oxygen and "secondary" metal element of the alloy present on the surface of the metal layer 21a is implemented by acting directly on the mechanisms and on the kinetics of the oxidation reactions occurring on such surface.

In particular, the formation of the barrier oxide layer mainly consists of two phases: a first phase called transition phase followed by a second phase called stationary phase.

During the transition phase the nucleation and subsequent growth of the barrier layer at the metal layer (21a) - ceramic layer (21b) interface take place. In the present case, the oxidation reaction speed during the transition phase mainly depends upon the oxygen concentration present at the metal layer 21a - ceramic layer 21b interface and upon that which the interface reaches by spreading through the ceramic layer 21b.

The transition phase is followed by the growth stationary phase of the barrier oxide layer during which the interface mainly involved by the oxidation reaction is the metal layer 21a - barrier oxide layer one. In this case, the oxide growth speed always depends upon the oxygen concentration which, this time, has to spread through the ceramic layer 21b and then through the barrier oxide layer which has formed during the transition phase. Consequently, the barrier oxide growth speed in the stationary phase results to be much lower than that observed during the transition phase, since the oxygen amounts reaching the "secondary" metal at the metal layer 21a - barrier oxide layer interface are much lower.

The oxygen amount involved in the several growth phases of barrier oxide layer depend upon the operating temperature of the protective structure 21, the stoichiometry and the thickness of the ceramic layer 21b deposited on the metal layer 21a.

Hereinafter, the reflector in the infrared region 23 of the absorbing coating 2 is meant consisting of one or more layers; analogously, the absorber of the solar radiation 22 and the anti-reflective coating 24 in turn comprise one or more layers.

With reference to figure 2, a first example of absorbing coating 2 provides said protective structure 21 positioned between the absorber 22 and the anti-reflective coating 24 of an absorbing coating 2 devised to work under vacuum.

In this example, the absorbing coating 2 for receivers acting in air comprises in sequence:
- an infrared reflective coating 23 arranged in contact with the substrate 1;
- an absorber 22;
- a protective structure 21;
- an anti-reflective coating 24.

The protective structure 21 protects the metal components of the spectrally selective absorbing coating 2 devised to work under vacuum, consisting of 23, 22 and 24, thus by making it suitable to work in air.

In the proposed sequence, the metal layer 21a of the protective structure 21 participates in the formation of the absorbing element and it has a thickness comprised between 1 and 80 nm, preferably comprised between 10 and 30 nm, so as to be sufficiently thick to guarantee the formation of a barrier oxide at the operating temperature of the absorbing coating 2 and sufficiently thin to allow the different underlying layers to carry out the functions they have been devised for. The ceramic layer 21b of the protective structure 21 participates in the formation of the anti-reflective coating of the absorbing coating 2 and it has a thickness comprised between 1 and 250 nm, preferably between 5 and 60 nm.

In another example, the absorbing coating 2 for receivers acting in air comprises in sequence:
- an infrared reflective coating 23 arranged in contact with the substrate 1;
- an absorber 22;
- a protective structure 21.

In the proposed sequence, the metal layer 21a of the protective structure 21 participates in the formation of the absorbing element and it has a thickness comprised between 1 and 80 nm, preferably comprised between 10 and 30 nm, to guarantee the formation of the barrier oxide and the transparency required to make the underlying layers to carry out the functions they have been devised for. The ceramic layer 21b of the protective structure 21 carries out the anti-reflective function of the absorbing coating 2 and it has a thickness comprised between 1 and 250 nm, preferably between 20 and 120 nm.

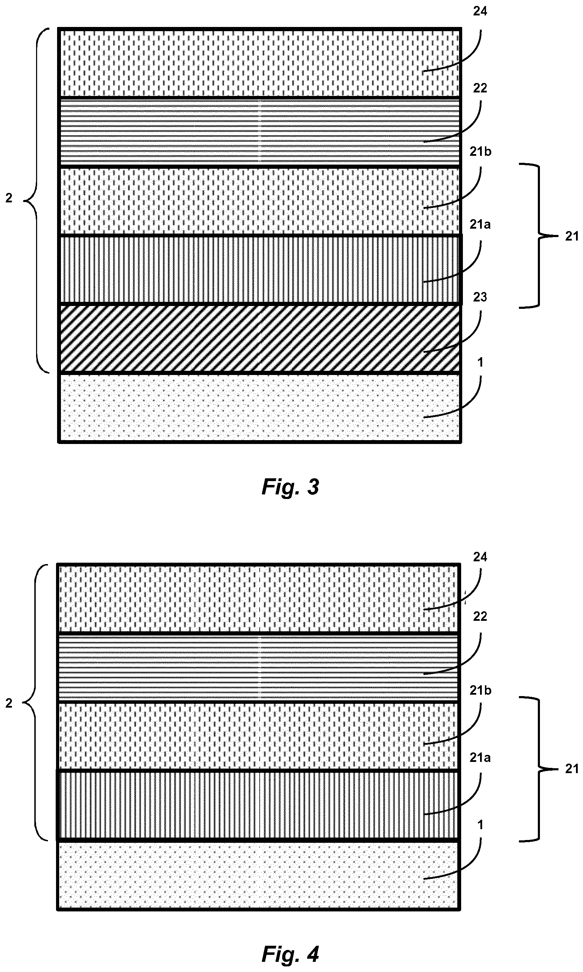

With reference to figure 3, an additional example of absorbing coating 2 for receivers acting in air comprises in sequence:
- an infrared reflective coating 23 arranged in contact with the substrate 1;
- a protective structure 21;
- an absorber, comprising a metal component consisting of one of the alloys of the metal layer 21a of the protective structure 21 and a ceramic component consisting of one of the oxides of the ceramic layer 21b of the protective structure 21;
- an anti-reflective coating 24.

The infrared reflective coating 23 consists in a transition metal selected in the group consisting of: Ti, V, Cr, Zr, Nb, Mo, Hf, Ta, W or a nitride of one of said transition metals. The thickness of the infrared reflective coating 23 is comprised between 1 and 250 nm, preferably between 90 and 150 nm, so as to reflect effectively in the infrared.

In case of operating temperature of the receiver from 600°C to 800°C, said transition metal can be selected in the group consisting of: Ti, Zr, Mo, W, TiN and ZrN.

The coupling between the protective structure 21 and the infrared reflective coating 23 is preferably implemented, where possible, by selecting the "primary" metal of the alloy constituting the metal layer 21a of the protective structure 21 equal to the one of the metal of the infrared reflective coating 23.

In case of operating temperature of the receiver up to 600°C, the infrared reflective coating 23 comprises the following two layers arranged in sequence:
- a barrier layer, arranged in contact with the substrate 1 and with function of barrier and adhesion layer, comprising a transition metal selected in the group consisting of: Ti, V, Cr, Zr, Nb, Mo, Hf, Ta, W or a nitride of one of said transition metals;
- a layer consisting of a highly reflective metal selected in the group consisting of: Au, Ag and Cu.

In this way, the advantageous optical behaviour of Au, Ag and Cu can be used and their poor structural and chemical-physical stability at high temperatures, poor adhesion to the substrate 1 and ineffective barrier to the spreading phenomena from the substrate 1 can be compensated by inserting them in the absorbing coating 2 between the barrier layer and the protective structure 21.

When this combination of barrier layer and layer reflecting in the infrared is used, the barrier layer can have a thickness comprised between 1 and 250 nm, preferably between 90 and 150 nm, whereas the layer reflecting in the infrared has a thickness comprised between 1 and 250 nm, preferably between 90 and 150 nm, so as to reflect effectively in the infrared.

The metal layer 21a of the protective structure 21 can have a thickness comprised between 1 and 80 nm, preferably between 10 and 30 nm, so as to be sufficiently thick to guarantee the formation of a barrier oxide at the operating temperature of the absorbing coating 2 and at the same time sufficiently thin to allow the infrared reflective coating 23 to perform its function.

The ceramic layer 21b of the protective structure 21 can have a thickness comprised between 1 and 250 nm, preferably comprised between 5 and 60 nm.

The absorber 22 of the embodiment of figure 3 can be formed by one single protective structure 21 or by an alternation of several protective structures 21. The absorber 22, as first layer of said sequence, has the metal layer 21a arranged in contact with the protective structure 21 not belonging to the absorber 22, and as last layer of said sequence it has the ceramic layer 21b arranged in contact with the anti-reflective coating 24.

The absorber 22 can include a minimum number of 2 layers up to a maximum of forty layers.

The metal layer 21a of each protective structure 21 can have a thickness comprised between 1 and 50 nm, preferably between 5 and 20 nm, so as to be sufficiently thick to guarantee both the formation of the barrier oxide at the operating temperature of the absorbing coating 2 and the absorption of the solar radiation. At last, the ceramic layer 21b of the protective structure 21 can have a thickness comprised between 1 and 120 nm, preferably between 10 and 40 nm.

As an alternative to the ceramic-metal multi-layered structure, another example of absorber 22 provides the use of sequences of one or more layers of Cermet material, with a metal component consisting of one of the alloys of the protective structure 21, and a ceramic component consisting of one of the oxides of the protective structure 21.

Each single layer of Cermet material can have a constant volumetric fraction of the metal component, and comprised between 0.01 and 0.49, preferably between 0.10 and 0.35, so that the clusters of the metal alloy are incorporated within the ceramic matrix of oxide type. Moreover, the metal clusters within each Cermet layer will have sizes so as to guarantee both the formation of the barrier oxide layer at the metal clusters-ceramic matrix interface and to have the absorbing function of the Cermet material.

The barrier oxide which forms at the metal clusters - ceramic matrix interface has the function of locking the spreading of the oxidizing agents present in the atmosphere towards the metal components of the absorber 22 and at the same time of locking the spreading of these metal components within the ceramic matrix by preserving the absorbing function of the Cermet layer.

Therefore, the thickness of each Cermet layer has to be comprised between 1 and 200 nm, preferably between 20 and 120 nm.

The absorber 22 can be formed by one single Cermet layer or by several layers until a maximum of twenty. With reference to figure 3, the anti-reflective coating 24 consists of a ceramic layer of sub-stoichiometric oxide of Al or Si or an alloy of Al and Si. The oxide of the ceramic layer of the anti-reflective coating 24 is deposited in sub-stoichiometric form so that its microstructure densifies once the absorbing coating 2 is brought at the operating temperature in air. The resulting anti-reflective coating 24 allows to minimize the reflection of the solar radiation incident on the absorbing coating 2, thanks to its dense and compact structure, and to reduce drastically the amounts of oxygen which can reach the absorber 22 and, then, the infrared reflective coating 23.

The thickness of the sub-stoichiometric oxide layer in said antireflective coating 24 is comprised between 1 and 200 nm, preferably between 20 and 120 nm.

Under these conditions, the formation of barrier oxides is favoured, capable of guaranteeing an excellent structural and chemical-physical stability to the absorbing coating 2 in air at the operating temperature.

With reference to figure 4, a last example of absorbing coating 2 uses the protective structure 21 directly as infrared reflective coating 23. In particular, the absorbing coating 2 comprises, in sequence:
- an infrared reflective coating 23 arranged in contact with the substrate 1, consisting of the metal layer 21a of said protective structure 21, whereon a ceramic layer 21b of the protective structure 21 is placed;
- an absorber 22, comprising a metal component consisting of one of the alloys of the metal layer 21a of the protective structure 21 and a ceramic component consisting of one of the oxides of the ceramic layer 21b of the protective structure 21;
- an anti-reflective coating 24.

The metal layer 21a which constitutes said infrared reflective coating 23 has a thickness comprised between 50 and 250 nm, preferably between 80 and 200 nm whereas the ceramic layer 21b placed above has a thickness comprised between 1 and 120 nm, preferably between 5 and 50 nm.

The absorber 22 and the anti-reflective coating 24 completing the absorbing coating 2, do not require additional descriptions since they are equal by functions and structure to those of the absorbing coating 2 described in figure 3.

According to the invention, a receiver acting in air for solar thermal and thermodynamic systems comprises one of the previously described solar absorbing coatings 2 and, in particular, a receiver tube comprises one of the above-described absorbing coatings 2 arranged on its tubular surface, generally made of steel, acting as substrate 1.

The receiver tube can be incapsulated by means of an additional glass tube comprising an anti-reflective treatment, two glass-metal junctions and elements (bellows) compensating the differential thermal expansions between steel tube and glass tube. The atmospheric air is left in the air gap between the receiver tube and the glass tube.

According to the invention, a process is provided for implementing an above-described absorbing coating on the substrate 1, by means of PVD deposition techniques, and in particular by means of high deposition speed sputtering techniques.

In this case, there may be provided: i) techniques of sputtering and magnetron co-sputtering, in argon, from metal targets ii) techniques of sputtering in argon + reactive gas (nitrogen, oxygen), from metal targets, iii) techniques of reactive magnetron co-sputtering, in argon + oxygen, from metal targets.

Under co-sputtering the simultaneous sputtering, in argon, starting from different material target is meant, whereas under reactive co-sputtering the simultaneous sputtering, in argon + oxygen, starting from different material target, is meant.

The invention can provide that the sputtering depositions are performed at a pressure comprised between 5x10⁻⁴ mbar and 5x10⁻² mbar, preferably between 1x10⁻³ mbar and 2x10⁻² mbar.

A possible thermal pre-treatment of the substrate 1 is implemented under vacuum at a pressure lower than 5x10⁻⁴ mbar, preferably lower than 1x10⁻⁴ mbar, and so as to bring the substrate 1 at a temperature comprised between 100°C and 300°C. On the contrary, a possible plasma pre-treatment is implemented, typically in Ar gas, at a pressure lower than 5x10⁻² mbar by means of polarization of the substrate 1, or at a pressure lower than 5x10⁻³ mbar by means of an ion source capable of implementing a high-energy ion bombardment of the substrate 1.

The metal layers of the protective structure 21, consisting of an alloy, can be applied by technique of magneton sputtering, in Ar gas, from targets formed by the specific alloy of interest, or by technique of magnetron co-sputtering, in Ar gas, from targets of the single metals composing the alloy; in this second case, the wished composition of the alloy will be obtained by varying suitably the input power of the targets of the single metals.

The ceramic layers 21b of the protective structure 21, consisting of an oxide of Al or Si, can be applied by technique of reactive magnetron sputtering, in Ar gas+O₂, with targets of Al or Si.

The ceramic layers 21b of the protective structure 21, consisting of an oxide of a binary alloy of Al and Si, can be applied by technique of reactive magnetron sputtering, in Ar gas+O₂, from targets formed by the specific alloy of interest, or by technique of reactive magnetron co-sputtering, in Ar gas+O₂, from targets of the single metals constituting the alloy fed with suitable powers.

The metal layers of the infrared reflective coating 23 can be applied by technique of magnetron sputtering, in Ar gas, from targets of the above-mentioned metal.

The layers with metal behaviour of the infrared reflective coating 23, consisting of a nitride of a transition metal, can be applied by technique of reactive magnetron sputtering, in Ar gas+N₂, from targets of the above-mentioned transition metal.

The Cermet layers of the absorber 22 can be applied by means of one of the following techniques:
- reactive co-sputtering, that is simultaneous sputtering, in Ar gas+O₂, starting from targets made of different material, with at least a target capable of producing the Cermet metal component and at least a target capable of producing the Cermet ceramic component;
- sputtering in Ar gas starting from at least a target capable of producing the Cermet metal component and subsequent reactive sputtering in Ar gas+O₂ starting from at least a target capable of producing the Cermet ceramic component.

In the present case, the Cermet layers, with metal component consisting of an alloy and with ceramic component consisting of an oxide of Al or Si or of an oxide of a binary alloy of Al and Si, can be applied starting from the following targets:
For the alloy deposition:
   - target of the above-mentioned alloy, or
   - target of the single metals composing the alloy of interest, fed with a suitable power;
For the deposition of oxide of Al or Si or, respectively, of the oxide of the binary alloy of Al and Si:
   - target of Al or target of Si, or
   - target of the above-mentioned binary alloy of Al and Si, or target of Al and Si, fed with a suitable power.

The ceramic layers of the anti-reflective coating 24 of the absorbing coating 2, consisting of an oxide of Al or Si, can be applied by technique of reactive magnetron sputtering, in Ar gas+O₂, from targets of Al or Si.

The ceramic layers of the anti-reflective coating 24, consisting of an oxide of a binary alloy of Al and Si, can be applied by technique of reactive magnetron sputtering, in Ar gas+O₂, from targets formed by the specific alloy of interest, or by technique of reactive magnetron co-sputtering, in Ar gas+O₂, from targets of the single metals composing the alloy fed with suitable powers.

In order to guarantee that, in the absorbing coating 2 the oxides are implemented in sub-stoichiometric form these deposition processes are performed "in transition regime" by means of reactive gas flow control system, in particular by means of control systems of PEM (Plasma Emission Monitoring) or CVM (Cathode Voltage Monitoring) type.

Preferably, said process comprises an additional thermal treatment of the absorbing coating 2 applied on the substrate 1, performed in air or by using gaseous mixtures with controlled oxidative potential and at temperature higher than or equal to 500°C, if the use temperature of a solar receiver comprising said spectrally selective absorbing coating 2 is lower than or equal to 450°C, by increasing the treatment temperature by at least 50°C with respect to the use temperature of the receiver in case the use temperature of the receiver is higher than 450°C.

With reference to figure 1, it illustrates schematically a section view of the protective structure 21 which is constituted by a metal layer 21a made of metal alloy, the constituents thereof have to be at least two elements, whereon a ceramic layer 21b is placed formed by an oxide in sub-stoichiometric form.

The primary metal of the alloy can be selected in the group consisting of: W, Mo, Ta, Nb, Ni, Co, Cu, Hf, Fe, Ag, Au, Pt, Pd, Cr, Rh, whereas the secondary metal can be selected in the group consisting of: Cr, Al, Si, Ti, Zr.

A possible third metal can be provided, which can be selected in the group consisting of: Y, Ti, Zr.

According to a specific example of protective structure 21, the alloy of the metal layer 21a consists of W, Cr and Ti, and the ceramic layer 21b, instead, consists of an oxide of Al.

The following Table I shows the composition of the protective structure 21 in a preferred embodiment thereof.

**Table I**

| | | |
|---|---|---|
| Protective structure 21 | Metal layer 21a | WCrTi |
| | Ceramic layer 21b | AlₓO_{y} |

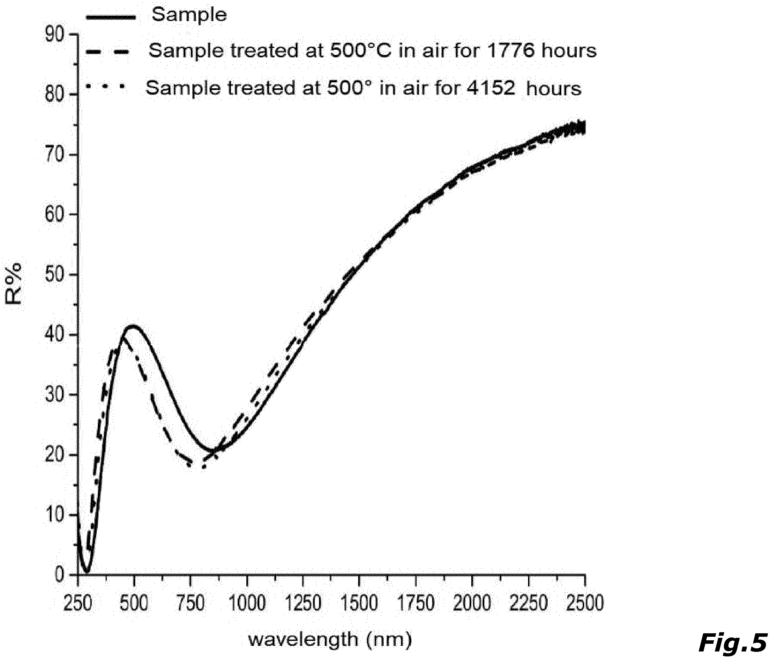

The protective structure 21 with the composition shown in table I was deposited on a substrate 1 made of steel. The metal layer of WCrTi was deposited in contact with the substrate 1 with a thickness of 140 nm, and with the following atomic percentages: 71.8% of W, 27.4% of Cr and 0.8% of Ti. On the metal layer 21a then a ceramic layer 21b of AlₓO_{y} with x=1 and y=1.3, and with a thickness of 100 nm, was deposited. The so constituted protective structure was subjected to two treatments in air at 500°C, the first one lasting 1776 hours, the second one 2376 hours. Before the thermal treatments, and after each thermal treatment, the reflectance of the protective structure 21 in the spectral range of 250-2500 nm was measured and figure 5 shows the courses thereof.

From the comparison of the reflectance's, it can be seen that only after the first thermal treatment there is a reflectance variation, mainly due to the formation of the barrier oxide at the metal layer 21a - ceramic layer 21b interface and to the compositional modification of the alumina oxide which transforms in the stoichiometric stable phase.

In the subsequent thermal treatment, no significant variations in the reflectance are noted to show the structural and chemical-physical stability of the protective structure 21.

Therefore, the oxide which forms at the metal layer 21a - ceramic layer 21b interface, carries out effectively the function of barrier to the spreading of the atmospheric oxidizing agents towards the metals of the layer 21a and, at the same time, it prevents these metals from spreading towards the ceramic layer 21b.

Moreover, the invariance of the optical properties of the structure also demonstrates that the growth speed of the barrier oxide at the metal layer 21a - ceramic layer 21b interface is very low. In conclusion, the result of the thermal treatments demonstrates that the protective structure 21 implemented for 500°C is potentially suitable to carry out the function of barrier to spreading for periods of time compatible with the life cycle of a solar receiver.

To the above-described spectrally selective absorbing coating for receivers acting in air of solar thermal and thermodynamic systems and of the related receiver, a person skilled in the art, with the purpose of fulfilling additional and contingent needs, could introduce several additional modifications and variants, however all within the protective scope of the present invention, as defined by the enclosed claims.

## Claims

1. A spectrally selective absorbing coating (2) for receivers acting in air in thermal and thermodynamic solar systems, arranged on a substrate (1), comprising at least one protective structure (21) capable of protecting the metal components of said protective structure (21) and of said absorbing coating (2) against the atmospheric oxidizing agents, which in turn comprises a metal layer (21a) whereon a ceramic layer (21b) is arranged, wherein:
• said metal layer (21a) consists of an alloy of at least a first and a second metal, the first metal, present in alloy with atomic percentages comprised between 50% and 90%, being selected in the group consisting of: W, Mo, Ta, Nb, Ni, Co, Cu, Hf, Fe, Ag, Au, Pt, Pd, Cr, Rh, and the second metal, present in alloy with atomic percentages comprised between 10% and 50%, being selected in the group consisting of: Cr, Al, Si, Ti, Zr, said second metal having Gibbs free energy of formation of its oxide lower than that of said first metal, wherein said metal alloy is not NiCr, HfZr; and
• said ceramic layer (21b) consists of a sub-stoichiometric oxide of a metal material selected in the group consisting of: Al, Si, alloy of Al and Si, said metal material having Gibbs free energy of formation of its oxide lower than or equal to that of said second metal.

2. The absorbing coating (2) according to claim 1, wherein said alloy is a ternary alloy consisting of said first metal, of said second metal and of a third metal selected in the group consisting of: Y, Ti, Zr, said third metal being present in alloy with atomic percentages comprised between 1% and 10%, wherein said metal alloy is not NiCrAlY.

3. The absorbing coating (2) according to claim 1 or 2, comprising in sequence: an infrared reflective coating (23) consisting of one or more layers and arranged in contact with the substrate (1), an absorber (22) consisting of one or more layers, the protective structure (21) and an anti-reflective coating (24) consisting of one or more layers.

4. The absorbing coating (2) according to claim 1 or 2, comprising in sequence: an infrared reflective coating (23) consisting of one or more layers arranged in contact with the substrate (1), an absorber (22) consisting of one or more layers and the protective structure (21).

5. The absorbing coating (2) according to claim 4, wherein said protective structure (21) is positioned so as to form the most external portion and in contact with the air of said absorbing coating (2).

6. The absorbing coating (2) according to claim 1 or 2, comprising in sequence: an infrared reflective coating (23) consisting of one or more layers and arranged in contact with the substrate (1), a protective structure (21), an absorber (22) consisting of one or more layers and an anti-reflective coating (24) consisting of one or more layers.

7. The absorbing coating (2) according to claim 6, wherein said infrared reflective coating (23) consists of a layer made of a transition metal selected in the group consisting of: Ti, V, Cr, Zr, Nb, Mo, Hf, Ta, W or of a nitride of one of said transition metals, with a thickness comprised between 1 and 250 nm, preferably between 90 and 150 nm.

8. The absorbing coating (2) according to claim 6, wherein said infrared reflective coating (23) for operating temperatures up to 600°C preferably consists of a first barrier layer implemented with a transition metal selected in the group consisting of: Ti, V, Cr, Zr, Nb, Mo, Hf, Ta, W or of a nitride of one of said transition metals, with a thickness comprised between 1 and 250 nm, preferably between 90 and 150 nm, and of a second layer reflecting in the infrared implemented with a metal selected in the group consisting of: Au, Ag and Cu, with a thickness comprised between 1 and 250 nm, preferably between 90 and 150 nm.

9. The absorbing coating (2) according to claim 1 or 2, comprising in sequence: an infrared reflective coating (23) consisting of said protective structure (21) arranged in contact with the substrate (1), an absorber (22) consisting of one or more layers and an anti-reflective coating (24) consisting of one or more layers.

10. The absorbing coating (2) according to claim 9 wherein said metal layer (21a) of said protective structure (21) has a thickness comprised between 50 and 250 nm, preferably between 80 and 120 nm, and said ceramic layer (21b) of said protective structure (21) has a thickness comprised between 1 and 120 nm, preferably between 5 and 50 nm.

11. The absorbing coating (2) according to any one of claims 6 to 10, wherein the absorber (22) consists of a sequence of one or more pairs formed by the metal layer (21a) and by the ceramic layer (21b), wherein the first layer of said sequence is arranged in contact with the protective structure (21) and the last layer of said sequence is arranged in contact with said anti-reflective coating (24).

12. The absorbing coating (2) according to any one of claims 6 to 10, wherein said absorber (22) consists of a sequence of one more layers of cermet material consisting of a metal component consisting of the alloy of the metal layer (21a), and of a ceramic component consisting of one of said oxides of the ceramic layer (21b), wherein the metal component is dispersed inside the ceramic component acting as matrix.

13. The absorbing coating (2) according to any one of claims 6 to 12, wherein the anti-reflective coating (24) consists of a layer consisting of a sub-stoichiometric oxide of Al or Si or an alloy of Al and Si, with a thickness comprised between 1 and 200 nm, preferably comprised between 20 and 120 nm.

14. A receiver acting in air for solar thermal and thermodynamic systems, comprising a substrate (1) and a spectrally selective absorbing coating (2) according to one of the preceding claims.

15. A process for implementing a spectrally selective absorbing coating (2), for receivers acting in air of solar thermal and thermodynamic systems, comprising the steps of:
• providing the substrate (1) of the receiver;
• applying a spectrally selective absorbing coating (2) overall or on a portion of the surface of the substrate (1) by means of PVD deposition techniques, in particular sputtering techniques,
wherein the metal layer (21a) of the protective structure (21) consists of an alloy of at least a first and a second metal, the first metal, present in alloy with atomic percentages comprised between 50% and 90%, being selected in the group consisting of: W, Mo, Ta, Nb, Ni, Co, Cu, Hf, Fe, Ag, Au, Pt, Pd, Cr, Rh, and the second metal, present in alloy with atomic percentages comprised between 10% and50%, being selected in the group consisting of: Cr, Al, Si, Ti, Zr, wherein said metal alloy is not NiCr, HfZr and said second metal having Gibbs free energy of formation of its oxide lower than that of said first metal, and wherein, the ceramic layer (21b) of the protective structure (21), deposited on said metal layer (21a), consists of a sub-stoichiometric oxide of a metal material selected in the group consisting of: Al, Si, alloy of Al and Si, said metal material having Gibbs free energy of formation of its oxide lower than or equal to that of said second metal.

16. The process according to claim 15, wherein said process comprises at least one pre-treatment of thermal type or by means of plasma or a combination thereof of the substrate (1), which precedes the application of absorbing coating (2) with the PVD deposition techniques.

## Patentansprüche

1. Spektral selektive absorbierende Beschichtung (2) für Empfänger, die in thermischen und thermodynamischen Solarsystemen in der Luft wirken, angeordnet auf einem Substrat (1), aufweisend mindestens eine Schutzstruktur (21), die in der Lage ist, die Metallkomponenten der Schutzstruktur (21) und der absorbierenden Beschichtung (2) vor den oxidierenden Mitteln der Atmosphäre zu schützen, die wiederum eine Metallschicht (21a) aufweist, auf der eine Keramikschicht (21b) angeordnet ist, wobei:
• Die Metallschicht (21a) aus einer Legierung aus mindestens einem ersten und einem zweiten Metall besteht, wobei das erste Metall, das in der Legierung mit einem Atomanteil zwischen 50% und 90% vorhanden ist, aus der Gruppe ausgewählt ist, bestehend aus: W, Mo, Ta, Nb, Ni, Co, Cu, Hf, Fe, Ag, Au, Pt, Pd, Cr, Rh und wobei das zweite Metall, das in der Legierung mit einem Atomanteil zwischen 10 % und 50 % vorhanden ist, aus der Gruppe ausgewählt ist, bestehend aus: Cr, Al, Si, Ti, Zr, wobei das zweite Metall eine Gibbs-freie Bildungsenergie seines Oxids aufweist, die niedriger ist als die des ersten Metalls, wobei die Metalllegierung nicht NiCr, HfZr ist; und
• die Keramikschicht (21b) aus einem substöchiometrischen Oxid eines Metallmaterials besteht, das aus der Gruppe ausgewählt ist, bestehend aus: Al, Si, einer Legierung aus Al und Si, wobei das Metallmaterial eine Gibbs-freie Bildungsenergie seines Oxids aufweist, die kleiner oder gleich der des zweiten Metalls ist.

2. Absorbierende Beschichtung (2) gemäß Anspruch 1, wobei die Legierung eine ternäre Legierung ist, die aus dem ersten Metall, dem zweiten Metall und einem dritten Metall besteht, das ausgewählt ist aus der Gruppe bestehend aus: Y, Ti, Zr, wobei das dritte Metall in der Legierung mit einem Atomanteil zwischen 1% und 10% vorliegt, wobei die Metalllegierung nicht NiCrAlY ist.

3. Absorbierende Beschichtung (2) gemäß Anspruch 1 oder 2, aufweisend in der Reihenfolge: eine infrarotreflektierende Beschichtung (23), bestehend aus einer oder mehreren Schichten und in Kontakt mit dem Substrat (1) angeordnet, einem Absorber (22), bestehend aus einer oder mehreren Schichten, der Schutzstruktur (21) und einer Antireflexbeschichtung (24), bestehend aus einer oder mehreren Schichten.

4. Absorbierende Beschichtung (2) gemäß Anspruch 1 oder 2, aufweisend in der Reihenfolge: eine infrarotreflektierende Beschichtung (23), bestehend aus einer oder mehreren Schichten, in Kontakt mit dem Substrat (1) angeordnet, einem Absorber (22), bestehend aus einer oder mehr Schichten und der Schutzstruktur (21).

5. Absorbierende Beschichtung (2) gemäß Anspruch 4, wobei die Schutzstruktur (21) so positioniert ist, dass sie den äußersten Teil bildet und mit der Luft der absorbierenden Beschichtung (2) in Kontakt steht.

6. Absorbierende Beschichtung (2) gemäß Anspruch 1 oder 2, aufweisend in der Reihenfolge: eine infrarotreflektierende Beschichtung (23), bestehend aus einer oder mehreren Schichten und in Kontakt mit dem Substrat (1) angeordnet, einer Schutzstruktur (21), einem Absorber (22), bestehend aus einer oder mehreren Schichten und einer Antireflexbeschichtung (24), bestehend aus einer oder mehreren Schichten.

7. Absorbierende Beschichtung (2) gemäß Anspruch 6, wobei die infrarotreflektierende Beschichtung (23) aus einer Schicht besteht, die aus einem Übergangsmetall hergestellt ist, das aus der Gruppe ausgewählt ist bestehend aus: Ti, V, Cr, Zr, Nb, Mo, Hf, Ta, W oder einem Nitrid eines der genannten Übergangsmetalle, mit einer Dicke zwischen 1 und 250 nm, vorzugsweise zwischen 90 und 150 nm.

8. Absorbierende Beschichtung (2) gemäß Anspruch 6, wobei die infrarotreflektierende Beschichtung (23) für Betriebstemperaturen bis zu 600 °C vorzugsweise aus einer ersten Barriereschicht besteht, die mit einem Übergangsmetall implementiert ist, das ausgewählt ist aus der Gruppe bestehend aus: Ti, V, Cr, Zr, Nb, Mo, Hf, Ta, W oder einem Nitrid eines der Übergangsmetalle, mit einer Dicke zwischen 1 und 250 nm, vorzugsweise zwischen 90 und 150 nm, und einer zweiten Schicht, die im Infrarotbereich reflektiert und mit einem Metall implementiert ist, das ausgewählt ist aus der Gruppe bestehend aus: Au, Ag und Cu mit einer Dicke zwischen 1 und 250 nm, vorzugsweise zwischen 90 und 150 nm.

9. Absorbierende Beschichtung (2) gemäß Anspruch 1 oder 2, aufweisend in der Reihenfolge: eine infrarotreflektierende Beschichtung (23), bestehend aus der Schutzstruktur (21), die in Kontakt mit dem Substrat (1) angeordnet ist, einem Absorber (22), bestehend aus einer oder mehreren Schichten, und einer Antireflexbeschichtung (24), bestehend aus einer oder mehreren Schichten.

10. Absorbierende Beschichtung (2) gemäß Anspruch 9, wobei die Metaschicht (21a) der Schutzstruktur (21) eine Dicke zwischen 50 und 250 nm, vorzugsweise zwischen 80 und 120 nm, aufweist, und die Keramikschicht (21b) der Schutzstruktur (21) eine Dicke zwischen 1 und 120 nm, vorzugsweise zwischen 5 und 50 nm, aufweist.

11. Absorbierende Beschichtung (2) gemäß einem der Ansprüche 6 bis 10, wobei der Absorber (22) aus einer Abfolge aus einem oder mehreren Paaren besteht, die durch die Metallschicht (21a) und durch die Keramikschicht (21b) gebildet werden, wobei die erste Schicht der Abfolge in Kontakt mit der Schutzstruktur (21) angeordnet ist und die letzte Schicht der Abfolge in Kontakt mit der Antireflexbeschichtung (24) angeordnet ist.

12. Absorbierende Beschichtung (2) gemäß einem der Ansprüche 6 bis 10, wobei der Absorber (22) aus einer Abfolge von einer oder mehreren Schichten aus Cermet-Material besteht, das aus einer Metallkomponente aus der Legierung der Metallschicht (21a) besteht, und aus einer Keramikkomponente, die aus einem der Oxide der Keramikschicht (21b) besteht, wobei die Metallkomponente innerhalb der als Matrix fungierenden Keramikkomponente dispergiert ist.

13. Absorbierende Beschichtung (2) gemäß einem der Ansprüche 6 bis 12, wobei die Antireflexbeschichtung (24) aus einer Schicht besteht, die aus einem substöchiometrischen Oxid von Al oder Si oder einer Legierung aus Al und Si besteht, mit einer Dicke zwischen 1 und 200 nm, vorzugsweise zwischen 20 und 120 nm.

14. Ein in Luft arbeitender Empfänger für solarthermische und thermodynamische Systeme, aufweisend ein Substrat (1) und eine spektral selektive absorbierende Beschichtung (2) gemäß einem der vorhergehenden Ansprüche.

15. Verfahren zum Implementieren einer spektral selektiven absorbierenden Beschichtung (2) für in Luft arbeitende Empfänger von solarthermischen und thermodynamischen Systemen, mit den folgenden Schritten:
• Bereitstellen des Substrats (1) des Empfängers;
• Aufbringen einer spektral selektiven absorbierenden Beschichtung (2) auf die gesamte oder einen Teil der Oberfläche des Substrats (1) mittels PVD-Abscheidungstechniken, insbesondere Sputtertechniken,
wobei die Metallschicht (21a) der Schutzstruktur (21) aus einer Legierung aus mindestens einem ersten und einem zweiten Metall besteht, wobei das erste Metall, das in der Legierung mit einem Atomanteil zwischen 50% und 90% vorhanden ist, aus der Gruppe ausgewählt ist, bestehend aus: W, Mo, Ta, Nb, Ni, Co, Cu, Hf, Fe, Ag, Au, Pt, Pd, Cr, Rh und wobei das zweite Metall, das in der Legierung mit einem Atomanteil zwischen 10 % und 50 % vorhanden ist, aus der Gruppe ausgewählt ist, bestehend aus: Cr, Al, Si, Ti, Zr, wobei die Metalllegierung nicht NiCr, HfZr ist, und wobei das zweite Metall eine Gibbs-freie Bildungsenergie seines Oxids aufweist, die niedriger ist als die des ersten Metalls, und wobei die Keramikschicht (21b) der Schutzstruktur (219, die auf der Metallschicht (21a) abgeschieden ist, aus einem substöchiometrischen Oxid eines Metallmaterials besteht, das aus der Gruppe ausgewählt ist, bestehend aus: Al, Si, einer Legierung aus Al und Si, wobei das Metallmaterial eine Gibbs-freie Bildungsenergie seines Oxids aufweist, die kleiner oder gleich der des zweiten Metalls ist.

16. Verfahren gemäß Anspruch 15, wobei das Verfahren mindestens eine Vorbehandlung thermischer Art oder mittels Plasma oder einer Kombination davon des Substrats (1) aufweist, die der Aufbringung der absorbierenden Beschichtung (2) mit den PVD-Abscheidungstechniken vorausgeht.

## Revendications

1. Revêtement absorbant spectralement sélectif (2) pour récepteurs agissant dans l'air dans des systèmes solaires thermiques et thermodynamiques, disposé sur un substrat (1), comprenant au moins une structure de protection (21) pouvant protéger les composants métalliques de ladite structure de protection (21) et dudit revêtement absorbant (2) contre les agents oxydants atmosphériques, qui comprend à son tour une couche métallique (21a) sur laquelle est disposée une couche céramique (21b), dans lequel :
• ladite couche métallique (21a) est constituée d'un alliage d'au moins un premier et un deuxième métal, le premier métal, présent dans l'alliage avec des pourcentages atomiques compris entre 50 % et 90 %, étant choisi dans le groupe constitué de : W, Mo, Ta, Nb, Ni, Co, Cu, Hf, Fe, Ag, Au, Pt, Pd, Cr, Rh, et le deuxième métal, présent dans l'alliage avec des pourcentages atomiques compris entre 10 % et 50 %, étant choisi dans le groupe constitué de : Cr, Al, Si, Ti, Zr, ledit deuxième métal ayant une énergie libre de Gibbs de formation de son oxyde inférieure à celle dudit premier métal, dans lequel ledit alliage métallique n'est pas NiCr, HfZr ; et
• ladite couche céramique (21b) est constituée d'un oxyde sub-stœchiométrique d'un matériau métallique choisi dans le groupe constitué de : Al, Si, alliage d'Al et de Si, ledit matériau métallique ayant une énergie libre de Gibbs de formation de son oxyde inférieure ou égale à celle dudit deuxième métal.

2. Revêtement absorbant (2) selon la revendication 1, dans lequel ledit alliage est un alliage ternaire constitué dudit premier métal, dudit deuxième métal et d'un troisième métal choisi dans le groupe constitué de : Y, Ti, Zr, ledit troisième métal étant présent dans l'alliage avec des pourcentages atomiques compris entre 1 % et 10 %, dans lequel ledit alliage métallique n'est pas NiCrAlY.

3. Revêtement absorbant (2) selon la revendication 1 ou 2, comprenant dans l'ordre : un revêtement réfléchissant les infrarouges (23) constitué d'une ou plusieurs couches et placé en contact avec le substrat (1), un absorbeur (22) constitué d'une ou plusieurs couches, la structure de protection (21) et un revêtement antireflet (24) constitué d'une ou plusieurs couches.

4. Revêtement absorbant (2) selon la revendication 1 ou 2, comprenant dans l'ordre : un revêtement réfléchissant les infrarouges (23) constitué d'une ou plusieurs couches disposées en contact avec le substrat (1), un absorbeur (22) constitué d'une ou plusieurs couches et la structure de protection (21).

5. Revêtement absorbant (2) selon la revendication 4, dans lequel ladite structure de protection (21) est positionnée de manière à former la partie la plus externe et en contact avec l'air dudit revêtement absorbant (2).

6. Revêtement absorbant (2) selon la revendication 1 ou 2, comprenant dans l'ordre : un revêtement réfléchissant les infrarouges (23) constitué d'une ou plusieurs couches et disposé en contact avec le substrat (1), une structure de protection (21), un absorbeur (22) constitué d'une ou plusieurs couches et un revêtement antireflet (24) constitué d'une ou plusieurs couches.

7. Revêtement absorbant (2) selon la revendication 6, dans lequel ledit revêtement réfléchissant les infrarouges (23) est constitué d'une couche composée d'un métal de transition choisi dans le groupe constitué de : Ti, V, Cr, Zr, Nb, Mo, Hf, Ta, W ou d'un nitrure de l'un desdits métaux de transition, d'une épaisseur comprise entre 1 et 250 nm, de préférence entre 90 et 150 nm.

8. Revêtement absorbant (2) selon la revendication 6, dans lequel ledit revêtement réfléchissant les infrarouges (23) pour des températures de fonctionnement allant jusqu'à 600°C est constitué de préférence par une première couche barrière mise en œuvre avec un métal de transition choisi dans le groupe constitué de : Ti, V, Cr, Zr, Nb, Mo, Hf, Ta, W ou d'un nitrure de l'un desdits métaux de transition, d'une épaisseur comprise entre 1 et 250 nm, de préférence entre 90 et 150 nm, et d'une seconde couche réfléchissante dans l'infrarouge mise en œuvre avec un métal choisi dans le groupe constitué de : Au, Ag et Cu, avec une épaisseur comprise entre 1 et 250 nm, de préférence entre 90 et 150 nm.

9. Revêtement absorbant (2) selon la revendication 1 ou 2, comprenant dans l'ordre : un revêtement réfléchissant les infrarouges (23) constitué de ladite structure de protection (21) disposée en contact avec le substrat (1), un absorbeur (22) constitué d'une ou plusieurs couches et un revêtement antireflet (24) constitué d'une ou plusieurs couches.

10. Revêtement absorbant (2) selon la revendication 9, dans lequel ladite couche métallique (21a) de ladite structure de protection (21) a une épaisseur comprise entre 50 et 250 nm, de préférence entre 80 et 120 nm, et ladite couche céramique (21b) de ladite structure de protection (21) a une épaisseur comprise entre 1 et 120 nm, de préférence entre 5 et 50 nm.

11. Revêtement absorbant (2) selon l'une quelconque des revendications 6 à 10, dans lequel l'absorbeur (22) est constitué d'une séquence d'une ou plusieurs paires formées par la couche métallique (21a) et par la couche céramique (21b), dans lequel la première couche de ladite séquence est disposée en contact avec la structure de protection (21) et la dernière couche de ladite séquence est disposée en contact avec ledit revêtement antireflet (24).

12. Revêtement absorbant (2) selon l'une quelconque des revendications 6 à 10, dans lequel ledit absorbeur (22) est constitué d'une séquence d'une ou plusieurs couches de matériau cermet constitué d'un composant métallique constitué de l'alliage de la couche métallique (21a), et d'un composant céramique constitué de l'un desdits oxydes de la couche céramique (21b), dans lequel le composant métallique est dispersé à l'intérieur du composant céramique agissant en tant que matrice.

13. Revêtement absorbant (2) selon l'une quelconque des revendications 6 à 12, dans lequel le revêtement antireflet (24) consiste en une couche constituée d'un oxyde sub-stœchiométrique d'Al ou de Si ou d'un alliage d'Al et de Si, d'une épaisseur comprise entre 1 et 200 nm, de préférence comprise entre 20 et 120 nm.

14. Récepteur agissant dans l'air pour systèmes solaires thermiques et thermodynamiques, comprenant un substrat (1) et un revêtement absorbant spectralement sélectif (2) selon l'une des revendications précédentes.

15. Procédé de mise en œuvre d'un revêtement absorbant spectralement sélectif (2), pour des récepteurs agissant dans l'air de systèmes solaires thermiques et thermodynamiques, comprenant les étapes suivantes :
• fournir le substrat (1) du récepteur ;
• appliquer un revêtement absorbant spectralement sélectif (2) sur l'ensemble ou sur une partie de la surface du substrat (1) au moyen de techniques de dépôt en phase vapeur par procédé physique (PVD), en particulier des techniques de pulvérisation cathodique,
dans lequel la couche métallique (21a) de la structure de protection (21) est constituée d'un alliage d'au moins un premier et un deuxième métal, le premier métal, présent dans l'alliage avec des pourcentages atomiques compris entre 50 % et 90 %, étant choisi dans le groupe constitué de : W, Mo, Ta, Nb, Ni, Co, Cu, Hf, Fe, Ag, Au, Pt, Pd, Cr, Rh, et le deuxième métal, présent dans l'alliage avec des pourcentages atomiques compris entre 10 % et 50 %, étant choisi dans le groupe constitué de : Cr, Al, Si, Ti, Zr, dans lequel ledit alliage métallique n'est pas NiCr, HfZr et ledit deuxième métal ayant une énergie libre de Gibbs de formation de son oxyde inférieure à celle dudit premier métal, et dans lequel la couche céramique (21b) de la structure de protection (21), déposée sur ladite couche métallique (21a), consiste en un oxyde sub-stœchiométrique d'un matériau métallique choisi dans le groupe constitué de : Al, Si, alliage d'AI et de Si, ledit matériau métallique ayant une énergie libre de Gibbs de formation de son oxyde inférieure ou égale à celle dudit deuxième métal.

16. Procédé selon la revendication 15, dans lequel ledit procédé comprend au moins un prétraitement de type thermique ou au moyen d'un plasma ou d'une combinaison de ceux-ci du substrat (1), qui précède l'application du revêtement absorbant (2) avec les techniques de dépôt PVD.
